Europäisches Patentamt

European Patent Office

Office européen des brevets

(11) Publication number: **0 023 792**
**B1**

# EUROPEAN PATENT SPECIFICATION

(45) Date of publication of patent specification: **30.01.85**

(51) Int. Cl.⁴: **G 11 C 11/40**

(21) Application number: **80302482.7**

(22) Date of filing: **22.07.80**

(54) Semiconductor memory device including integrated injection logic memory cells.

(30) Priority: **26.07.79 JP 95347/79**

(43) Date of publication of application:
**11.02.81 Bulletin 81/06**

(45) Publication of the grant of the patent:
**30.01.85 Bulletin 85/05**

(84) Designated Contracting States:
**DE GB NL**

(56) References cited:
**US-A-4 078 261**

**I.E.E.E. JOURNAL OF SOLID-STATE CIRCUITS,
vol. 14, no. 5, October 1979, NEW YORK (US)
GLÜCK and BUERKER: "An ECL 100K
compatible 1024x4 Bit RAM with 15 ns Access
Time"
I.B.M. TECHNICAL DISCLOSURE BULLETIN,
vol. 21, no. 11, April 1979 NEW YORK (US)
PETER: "Switchable clamp for memory sense
amplifier circuits"
IEEE Transactions on Electron Devices, Vol.
ED-26, no. 6, June 1979, "A 4K-bit Static +
Memory", pages 886-892**

(73) Proprietor: **FUJITSU LIMITED
1015, Kamikodanaka Nakahara-ku
Kawasaki-shi Kanagawa 211 (JP)**

(72) Inventor: **Toyoda, Kazuhiro
39-1433, Sakuradai
Midori-ku Yokohama-shi, Kanagawa 227 (JP)**

(74) Representative: **Abbott, Leonard Charles et al
GILL JENNINGS & EVERY 53-64 Chancery Lane
London WC2A 1HN (GB)**

Courier Press, Leamington Spa, England.

## Description

The present invention relates to a semiconductor device, and, more particularly, to a semiconductor integrated circuit device in which memory cells are of an I²L (which is an abbreviation for Integrated Injection Logic) type.

In general, each of the memory cells of a bipolar memory device comprises a pair of load transistors connected to one word line, a pair of cross-coupled transistors, connected to the load transistors, respectively, to one hold line and to a pair of bit lines, which serve as a flip-flop. In the bipolar memory cells, the resistance value of the load resistors are very large so as to reduce the power consumption thereof. Therefore, the area of the load resistors occupied in a chip is very large and, in addition, an isolation between the cross-coupled transistors is required. Consequently, the bipolar memory cells are large in size, which results in low integration density, and therefore, a high manufacturing cost of the bipolar memory device.

In recent years, an I²L memory device has been developed. In an I²L memory cell, a pair of load transistors which serve as injectors are used instead of the above-mentioned large load resistors and, in addition, no isolation between transistors within a row is required. As a result, a high integration density and low manufacturing cost can be attained. It should be noted that, such an I²L memory device can be manufactured by using conventional bipolar technology.

Usually, one I²L memory cell comprises a pair of first and second transistors of a first conduction type, such as a pnp type, which serve as injectors, a pair of cross-coupled third and fourth transistors of a second conduction type, such as an npn type, which serve as a flip-flop and a pair of fifth and sixth transistors of the second conduction type for detecting and reversing the state of the flip-flop in the read and write mode, respectively. The third and fourth transistors are always in the reverse conducting mode, in other words, the emitters and collectors of these transistors are used as collectors and emitters, respectively. In addition, when the memory cell is non-selected, the fifth and sixth transistors are also in the reverse conducting mode. Contrary to this, when the memory cell is selected, the fifth and sixth transistors are in the forward conducting mode.

In the above-mentioned I²L memory cell, one of the third and fourth transistors is conductive, while the other is nonconductive. If the third transistor is conductive, injection currents of the first and second transistors are supplied to the collector and base of the third transistor, respectively. In order to change the cell information, the third transistor must be changed to non-conductive. This is done by supplying an emitter current larger than a write threshold current $I_{wth}$, and therefore, by bypassing the base current of the third transistor to the base current of the fifth transistor cross-coupled to the third transistor. In this case, the write threshold current $I_{wth}$ depends on the total injection current $I_{inj}$ which flows through a common emitter of the first and second transistors. In other words, when the injection current $I_{inj}$ is large, the write threshold current $I_{wth}$ is large.

On the other hand, sink currents, which are explained below, flow from a selected memory cell to non-selected memory cells. The sink currents increase the injection current $I_{inj}$ of the selected memory cell and, accordingly, increase the write threshold current $I_{wth}$, so that the speed of the write operation becomes slow.

In order to decrease the sink currents flowing from a selected memory cell into non-selected memory cells, a clamp circuit is provided in one known I²L memory device, disclosed in an article entitled "A 4K-bit Static I²L Memory" in IEEE Transactions on Electron Devices, vol. ED-26, No. 6, June 1979. Each unit cell comprises a pair of injector transistors and a pair of cross-coupled transistors each having an additional collector for connection to a bit line. The clamp circuit comprises a plurality of pairs of clamp transistors, each connected to each of the pairs of bit lines. In a write mode, a high voltage is applied to the bases of the clamp transistors, so that sink currents flow into non-selected memory cells from the clamp transistors.

However, in a selected column of the above-mentioned conventional device, in which a pair of bit lines are selected, since a write current $I_w$ is usually much larger than a sink current $I_s$ or read current $I_R$, the difference in potential between the selected bit lines is also much larger during the read mode than during the write mode. Therefore, since the speed of the read operation depends on the difference in potential between the selected bit lines, the speed of the read operation of the above-mentioned device becomes slow.

It is a principal object of the present invention to provide a semiconductor integrated circuit memory device of an I²L type with high read operation speed.

According to the present invention, there is provided a semiconductor integrated circuit memory device comprising: a plurality of word lines; a plurality of word drivers, each connected to one of the word lines; a plurality of hold lines; a plurality of pairs of bit lines; a plurality of bit drivers, each connected to one of the pairs of bit lines; a plurality of memory cells of integrated injection logic, each memory cell including injectors comprising a pair of first and second transistors of a first conduction type which have a common emitter connected to one of the word lines; a flip-flop comprising a pair of cross-coupled third and fourth transistors of a second conduction type, connected to the first and second transistors, respectively; transistor means coupling the third and fourth transistors to respective ones of one of the pairs of bit lines; the third and fourth transistors being connected to one of the hold lines; and clamping means comprising a plurality of clamp transistors, having emitters respectively connected to the bit lines, and characterized in that the clamping means clamps the lower potential of the two potentials of each bit line pair, and by an altering means for controlling the clamping means in accordance with a write enable signal to selectively alter the base potentials of the clamp transistors in accordance with the read mode and the write mode, so that the lower potential of the clamp potentials of the bit lines is lower during the write mode than the read mode. In this device, because the difference in potential between selected bit lines during the read mode is smaller than in the conventional device, the speed of read operation is high.

IBM Technical Disclosure Bulletin, Vol, 21, No. 11, April 1979, discloses a "switchable clamp for memory sense amplifier circuits" on pages 4550 and 4551. In this circuit, a faster data transition at the output of a sense circuit is obtained by clamping the lower potential of the base of an output circuit transistor, this base being connected between a sense amplifier transistor and its load, thereby reducing the voltage swing at the base so that the output circuit transistor turns on more rapidly.

US patent specification No. 4078261 discloses a memory circuit using flip-flop cells comprising dual-emitter transistors and resistor loads, the cells being coupled to a pair of bit conductors; means coupled between the bit conductors and a sense circuit isolate the sense circuit from the storage cell during a writing operation. Because the magnitude of voltage swings of the bit lines to change the storage state of a cell is reduced, the writing speed is improved.

The present invention will be more clearly understood from the following description with reference to the accompanying drawings, wherein:

Fig. 1 is a circuit diagram illustrating an equivalent circuit of one I²L memory cell;

Fig. 2 is a cross-sectional view of the I²L memory cell of Fig. 1;

Fig. 3 is a block diagram illustrating a conventional I²L memory device;

Fig. 4 is a diagram showing potential levels, for explaining the value of the clamp voltage $V_c$ of the clamp circuit CL of Fig. 3;

Fig. 5 is a circuit diagram of the memory cells $C_{00}$ and $C_{10}$ of Fig. 3, for explaining the read operation of the device of Fig. 3;

Figs. 6A and 6B are timing diagrams of the signals appearing in the circuit of Fig. 5;

Fig. 6C is a timing diagram according to the present invention, corresponding to Fig. 6B;

Figs. 7 and 8 are circuit diagrams illustrating first and second embodiments of the I²L memory device according to the present invention;

Fig. 9 is a timing diagram of the signals appearing in the device of Fig. 8, and;

Fig. 10 is a circuit diagram of a third embodiment of the I²L memory device according to the present invention.

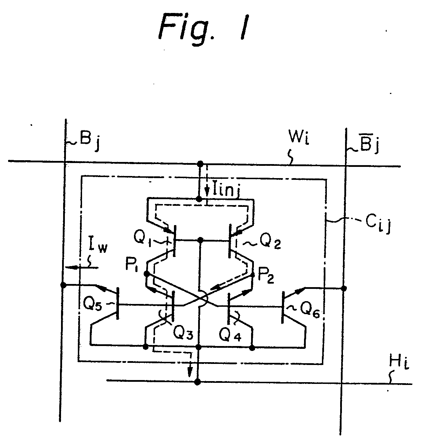

Referring to Fig. 1, which illustrates an equivalent circuit of one I²L memory cell, a memory cell $C_{ij}$ comprises a pair of transistors $Q_1$ and $Q_2$ of a pnp type which serve as injectors, a pair of transistors $Q_3$ and $Q_4$ of an npn type which are cross-coupled to each other and serve as a flip-flop, and a pair of transistors $Q_5$ and $Q_6$ of an npn type for detecting and reversing the state of the flip-flop in the read and write mode, respectively. The transistors $Q_1$ and $Q_2$ have a common emitter connected to a word line $W_i$ and collectors connected to collectors (which are represented as emitters in Fig. 1) of the transistors $Q_3$ and $Q_4$, respectively. The bases of the transistors $Q_1$ and $Q_2$, the emitters of the transistors $Q_3$ and $Q_4$, and the collectors of the transistors $Q_5$ and $Q_6$ are connected to a common hold line $H_i$. In addition, the emitters of the transistors $Q_5$ und $Q_6$ are connected to bit lines $B_j$ and $\overline{B}_j$, respectively.

The selection of the memory cell $\overline{C}_{ij}$ is effected by raising the potential of the word line $W_i$ and by connecting the bit lines $B_j$ and $\overline{B}_j$ to data bit lines (not shown), to which current sources (not shown) are connected. The transistors $Q_3$ and $Q_4$ are in the reverse conducting mode, regardless of the selected or non-selected state of the memory cell $C_{ij}$. Contrary to this, the transistors $Q_5$ and $Q_6$ are in the forward conducting mode during the selected state of the memory cell $C_{ij}$, while the transistors $Q_5$ and $Q_6$ are in the reverse conducting mode during the non-selected state of the memory cell $C_{ij}$.

In Fig. 1, the transistors $Q_3$ and $Q_4$ are placed in the on and off state alternatively. For example, when the transistor $Q_3$ is conductive, an injection current $I_{inj}$ is supplied to the transistor $Q_3$ as a base current and a collector current through the transistors $Q_1$ and $Q_2$, respectively. As a result, the transistor $Q_3$ is in a saturated state, so that the potential at $P_1$ is low and, accordingly, the transistor $Q_4$ is non-conductive. In order to change the information stored in the memory cell $C_{ij}$, the transistor $Q_3$ should be changed from conductive to non-conductive. This is done by supplying a write current $I_w$ larger than a write threshold current $I_{wth}$ to the emitter of the transistor $Q_5$, so that the base of the transistor $Q_5$ absorbs the base current of the transistor $Q_3$. As a result, the transistor $Q_3$ is changed from a saturated state to a non-saturated state, so that the potential at $P_1$ becomes high. Therefore, the transistor $Q_4$ becomes conductive and the potential at $P_2$ becomes low, so that the transistor $Q_3$ becomes non-conductive. That is, the state of the flip-flop formed by the transistors $Q_3$ and $Q_4$ is reversed.

In the above-mentioned write mode, the write threshold current $I_{wth}$ depends on the in-

jection current $I_{inj}$. Therefore, the write threshold current $I_{wth}$ is large where the injection current $I_{inj}$ is large.

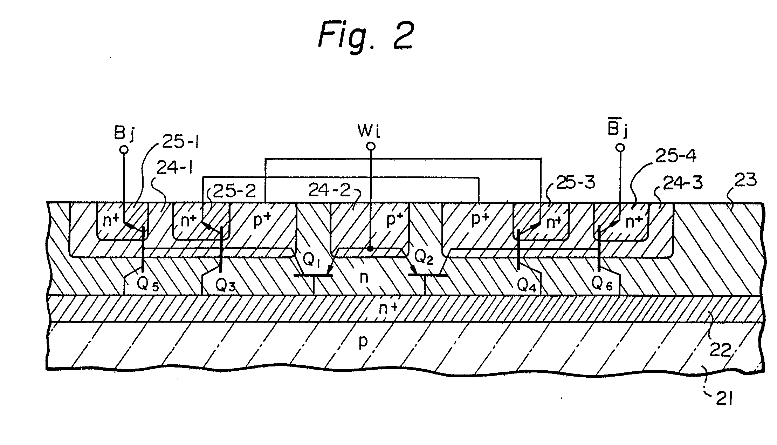

Fig. 2 is a cross-sectional view of the I²L memory cell of Fig. 1. In Fig. 2, an n⁺-type buried layer 22, which serves as the hold line $H_i$ (Fig. 1), is formed in a p-type substrate 21 by using conventional diffusion technology. In addition, an n-type epitaxial layer 23 is formed on the buried layer 22 by using epitaxial technology. Further, in the epitaxial layer 23, P⁺-type diffusion layers 24-1, 24-2 and 24-3 are formed, and in addition, in the p⁺-type diffusion layers 24-1, 24-2 and 24-3, n⁺-type diffusion layers 25-1, 25-2, 25-3, 25-4 are formed by using conventional diffusion technology. As illustrated in Fig. 2, the injection transistors $Q_1$ and $Q_2$ are of a lateral type, while the transistors $Q_3$ and $Q_5$ (and $Q_4$ and $Q_6$) are formed by one vertical transistor with multiple collectors. In the memory cell of Fig. 2, it should be noted that there is no resistor of high resistance and no isolation between the transistors $Q_1$ through $Q_6$, so that the memory cells can be formed in a high density.

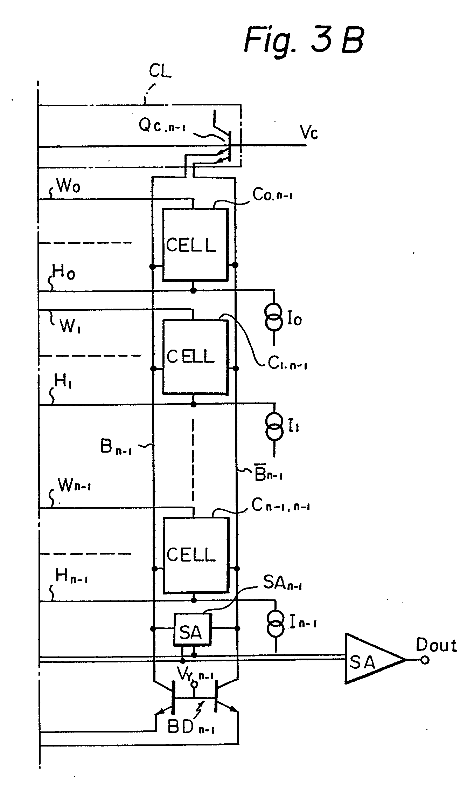

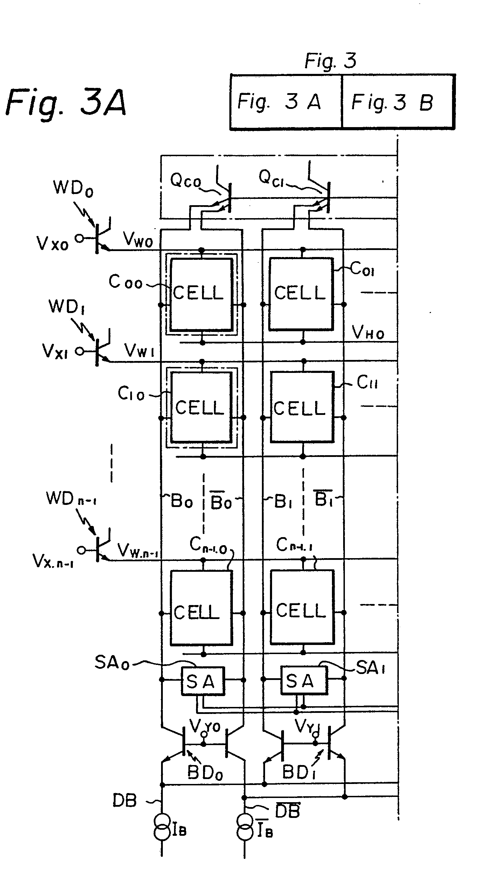

Fig. 3 is a block diagram illustrating a conventional I²L memory device. In Fig. 3, a memory array which is comprised of memory cells $C_{ij}$ (i, j=0, 1, ..., n−1), which are arranged in an n row, n column matrix, is shown. Each of the memory cells $C_{ij}$ can be selected by supplying row selection signals $V_{X0}$ through $V_{X,n−1}$ to word decorders $WD_0$ through $WD_{n−1}$ and by supplying column selection signals $V_{Y0}$ through $V_{Y,n−1}$ to bit drivers $BD_0$ through $BD_{n−1}$. Sense amplifiers indicated by the references $SA_0$, ..., $SA_{n−1}$ detect the data stored in the memory cells.

In the above-mentioned device, a clamp circuit CL is provided so as to supply sink currents into non-selected memory cells. Therefore, an injection current in a selected memory cell can be stable. For example, when the potentials of only the signals $V_{X0}$ and $V_{Y0}$ are high, the memory cell $C_{00}$ is selected and the memory cells $C_{01}$, $C_{02}$, ..., $C_{0,n−1}$, which belong to the word line $W_0$, are half-selected. In addition, the other memory cells are non-selected. A clamp voltage $V_C$ of the clamp circuit CL should be determined between two values which will now be explained.

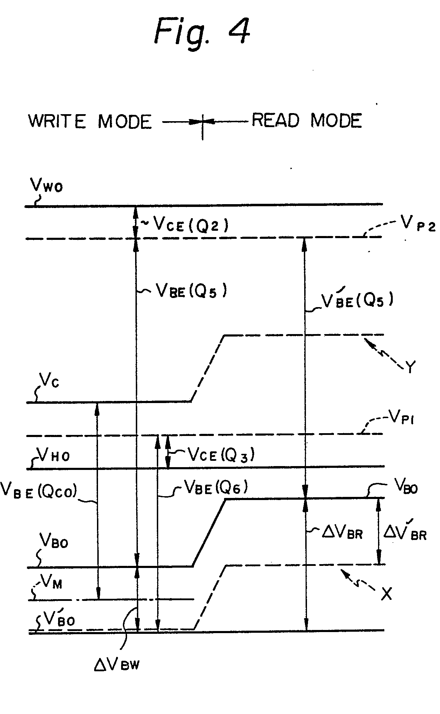

Fig. 4 is a diagram showing potential levels, for explaining the value of the clamp voltage $V_C$ of the clamp circuit CL of Fig. 3. In Fig. 4, $V_{W0}$ and $V_{H0}$ indicate the potentials of the word line $W_0$ and the hold line $H_0$, and; $V_{P1}$ and $V_{P2}$ indicate the potentials at $P_1$ and $P_2$ (see, Fig. 1), respectively, of the memory cell $C_{00}$, which potentials are represented as follows.

$$V_{P1}=V_{H0}+V_{CE}(Q_3)$$

$$v_{P2}=V_{W0}-V_{CE}(Q_2)$$

where $V_{CE}(Q_3)$ and $V_{CE}(Q_2)$ are collector-emitter

voltage of the transistors $Q_3$ and $Q_2$ (Fig. 1), respectively. In this case, the transistors $Q_3$ and $Q_4$ (Fig. 1) of the cell $C_{00}$ are conductive and non-conductive, respectively.

In addition, in the write mode, the potential $V_{B0}$ of the bit line $B_0$ should satisfy the following formula, so that the write current $I_W$ can flow from the transistor $Q_5$ (Fig. 1) into the bit line $B_0$.

$$V_{B0}=V_{P2}-V_{BE}(Q_5)$$

where $V_{BE}(Q_5)$ is a base-emitter voltage of the transistor $Q_5$.

On the other hand, the potential $V'_{B0}$ of the bit line $\bar{B}_0$ should satisfy the following formula, so that no sink current can flow from the transistor $Q_6$ (Fig. 1) of the selected cell $C_{00}$ to non-selected memory cells.

$$V'_{B0}=V_{P1}-V_{BE}(Q_6)$$

where $V_{BE}(Q_6)$ is a base-emitter voltage of the transistor $Q_6$.

Therefore, for example, the clamp voltage $V_C$ is caused to be

$$V_M+V_{BE}(Q_{C0}),$$

where $V_M$ is

$$(V_{B0}-V'_{B0})/2$$

and $V_{BE}(Q_{C0})$ is a base-emitter voltage of a multi-emitter transistor $Q_{C0}$ of the clamp circuit CL.

Contrary to above, in the read mode, a read current $I_R$ or a sink current $I_S$ which is much smaller than the write current $I_W$ flows through the transistor $Q_5$, so that the base-emitter voltage $V'_{BE}(Q_5)$ of the transistor $Q_5$ in the read mode is much smaller than the base-emitter voltage $V_{BE}(Q_5)$ of the transistor $Q_5$ in the write mode. Therefore, the difference $\Delta V_{BR}$ in the read mode is much larger than the difference $\Delta V_{BW}$, which results in a deterioration of the read operation. The read operation will now be explained.

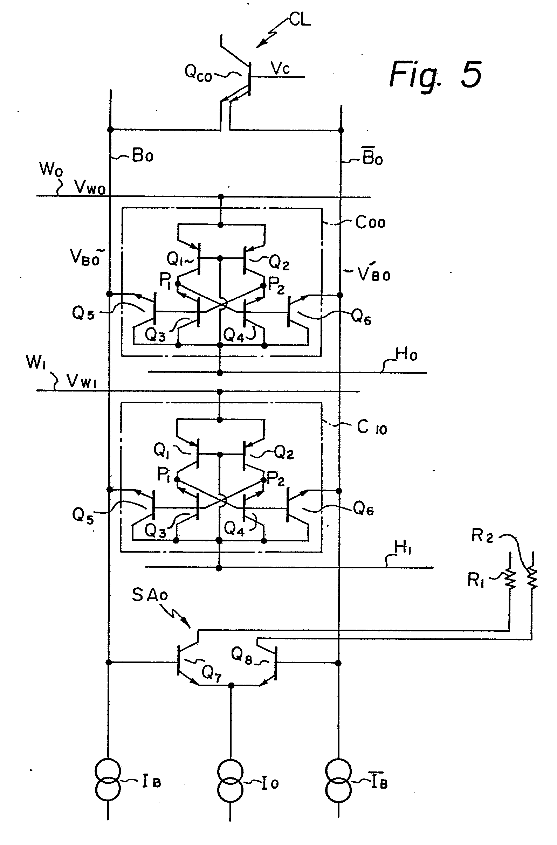

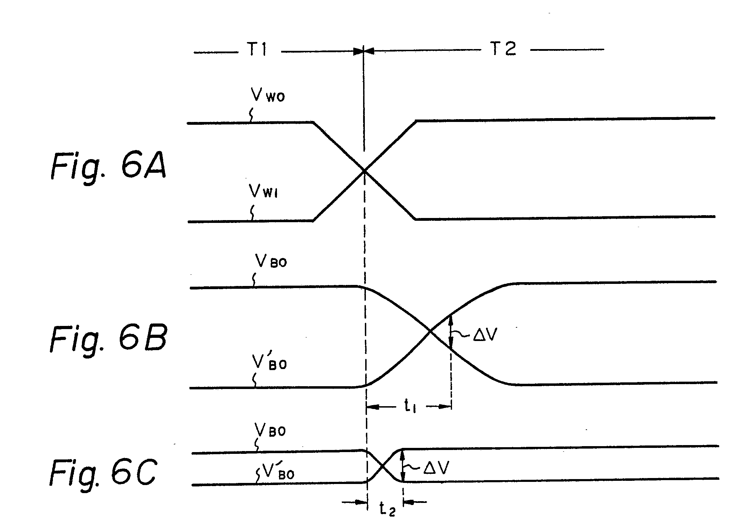

Fig. 5 is a circuit diagram of the memory cells $C_{00}$ and $C_{10}$ of Fig. 3, for explaining the read operation of the device of Fig. 3, and Figs. 6A and 6B are timing diagrams of the signals appearing in the circuit of Fig. 5. In Fig. 5, for a period T1, as shown in Figs. 6A and 6B, voltages $V_{W0}$ and $V_{W1}$ of the word lines $W_0$ and $W_1$ are high and low, respectively, that is, the memory cells $C_{00}$ and $C_{10}$ are selected and non-selected. In addition, in the memory cell $C_{00}$, the transistor $Q_3$ is conductive, while in the memory cell $C_{10}$, the transistor $Q_4$ is conductive. The difference in potential between the bit lines $B_0$ and $\bar{B}_0$, which difference is, for example, 0.8 volt, as illustrated in Fig. 6B, is detected by a differential read-out circuit $SA_0$ formed by two transistors $Q_7$ and $Q_8$. In addition, the detected currents $I_0$ are transformed to voltages, due to

resistors $R_1$ and $R_2$, which are supplied to an output circuit (not shown).

When the memory cell $C_{00}$ is changed from selected to non-selected and, simultaneously, the memory cell $C_{10}$ is changed from non-selected to selected, that is, when the voltage $V_{W0}$ is changed from high to low and, simultaneously, the voltage $V_{W1}$ is changed from low to high, as illustrated in Fig. 6A, the voltages $V_{B0}$ and $V'_{B0}$ are changed to low and high, respectively. Since a minimum difference $\Delta V$ which can be detected by the differential read-out circuit $SA_0$ is small, for example, 0.2 volt, it takes a time $t_1$ for the circuit $SA_0$ to detect the difference in potential between the two bit lines $B_0$ and $\overline{B}_0$. In particular, in a large-scale integrated memory device, bit lines to which a large number of memory cells are connected have large stray capacitances, so that the time $t_1$ in Fig. 6B becomes long and, accordingly, the speed of the read operation becomes slow.

In the present invention, the difference in potential between the bit lines during the read mode is almost the same as during the write mode. Therefore, the read-out time according to the present invention, which corresponds to a time $t_2$ in Fig. 6C, becomes shorter as compared with that of the conventional device, which corresponds to a time $t_1$.

It should be noted that, the higher one of the two potentials of the selected bit lines is determined by the potential of the selected word line and, accordingly, the higher potential cannot be changed. Therefore, in the present invention, the lower one of the two potentials of the selected bit lines is changed in response to the write mode or the read mode, which is illustrated by a dotted line X in Fig. 4, in which the difference $\Delta V'_{BR}$ is smaller than the difference $\Delta V_{BR}$.

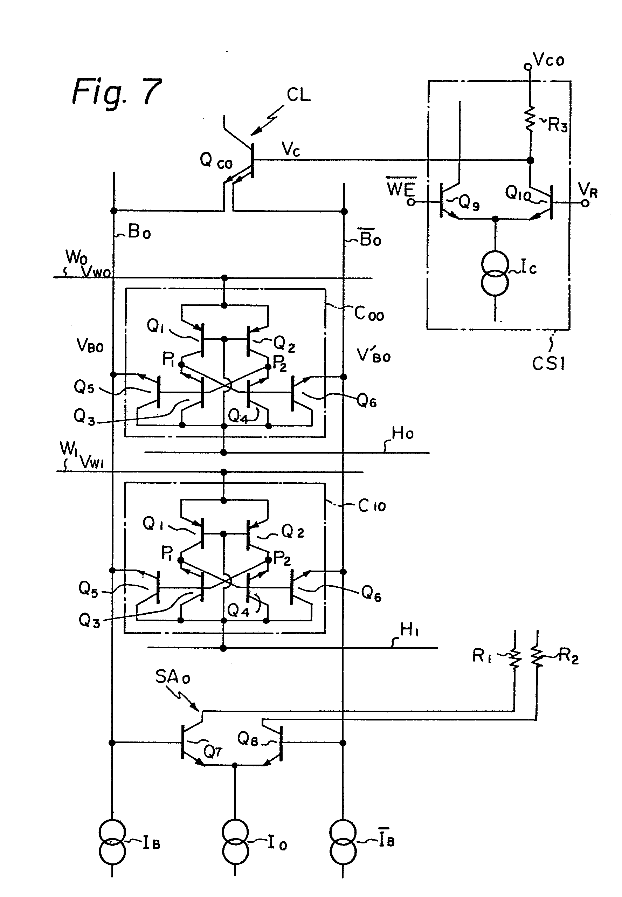

Fig. 7 is a circuit diagram illustrating a first embodiment of the I²L memory device according to the present invention. The elements illustrated in Fig. 7 which are identical to those of Fig. 5 are denoted by the same reference numerals. In Fig. 7, a current switching circuit CS1 which is comprised of a current switch formed by two transistors $Q_9$ and $Q_{10}$ is provided for controlling the clamp voltage $V_C$ of the clamp circuit CL. The transistors $Q_9$ and $Q_{10}$ are connected to a current source $I_C$ whose value is also represented by $I_C$, and in addition, the transistor $Q_{10}$ is connected to a resistor $R_3$. During the write mode, since a potential of an inverted signal of a write enable signal WE is lower than a reference voltage $V_R$, the transistor $Q_{10}$ is conductive, and accordingly, the current $I_C$ flows through the resistor $R_3$. As a result the clamp voltage $V_C$ becomes low. Therefore, the potentials $V_{B0}$ and $V'_{B0}$ are illustrated in the left side portion of Fig. 4. Contrary to this, during the read mode, since the potential of the signal $\overline{WE}$ is higher than the reference voltage $V_R$, the transistor $Q_9$ is conductive, and accordingly, the voltage $V_C$

becomes equal to $V_{C0}$ which is high, as illustrated in the right side portion of Fig. 4. As a result, the lower potential $V'_{B0}$ of the selected bit lines is higher during the read mode than during the write mode. It should be noted that the potential $V_{B0}$ is changed in response to whether a write current or a read current flows through the transistor $Q_5$, not in response to the clamp voltage $V_C$.

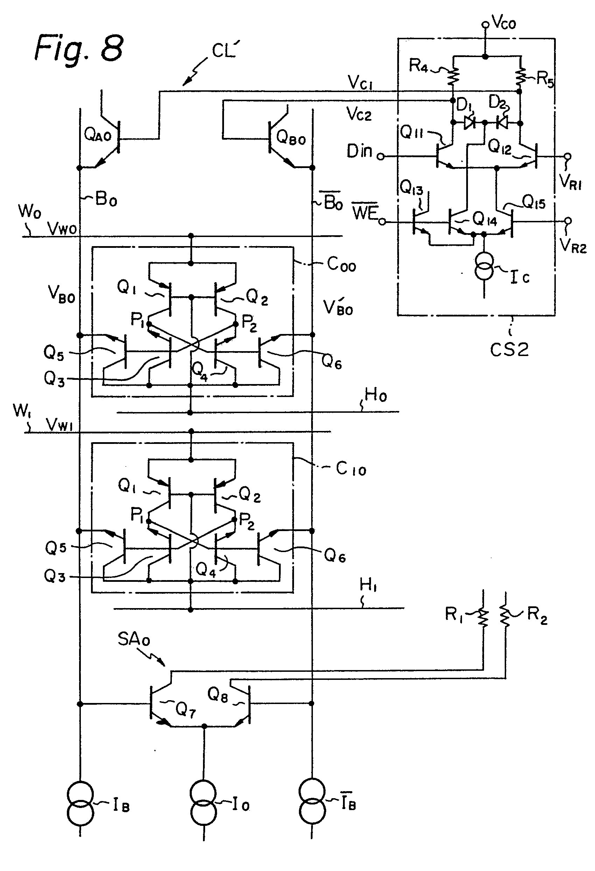

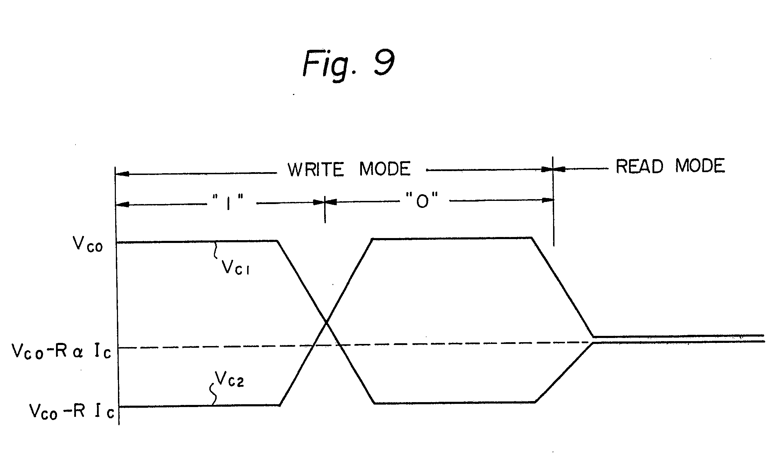

Fig. 8 is a circuit diagram illustrating a second embodiment of the I²L memory device according to the present invention. The elements in Fig. 8 which are identical to those of Fig. 5 are denoted by the same reference numerals. In Fig. 8, a current switching circuit CS2, which is comprised of two current switches, is provided for controlling clamp voltages $V_{C1}$ and $V_{C2}$ of a clamp circuit CL' formed by transistors $Q_{A0}$ and $Q_{B0}$. The transistors $Q_{11}$ and $Q_{12}$ are controlled by an input data signal $D_{in}$ and a reference voltage $V_{R1}$, respectively, while the transistors $Q_{13}$, $Q_{14}$ and $Q_{15}$ are controlled by the signal $\overline{WE}$ and a reference voltage $V_{R2}$. In addition, transistors $Q_{11}$ and $Q_{12}$ are connected to resistors $R_4$ and $R_5$, respectively, and to diodes $D_1$ and $D_2$, respectively, which diodes are connected in series to each other with opposite conducting directions. Further, the connection point of the diodes $D_1$ and $D_2$ is connected to the transistor $Q_{14}$. During the write mode, since the signal $\overline{WE}$ is lower than the reference voltage $V_{R2}$, the transistor $Q_{15}$ is conductive. In addition, when a write data is "1", that is, when the potential of the signal $D_{in}$ is higher than the reference voltage $V_{R1}$, the transistor $Q_{11}$ is conductive, and accordingly, the current $I_C$ flows through the resistor $R_4$, and the transistors $Q_{11}$ and $Q_{15}$. Therefore, the voltage $V_{C1}$ and $V_{C2}$ are high and low, respectively, as illustrated in Fig. 9. Contrary to this, when the write data is "0", that is, when the potential of the signal $D_{in}$ is lower than the reference voltage $V_{R1}$, the transistor $Q_{12}$ is conductive, and accordingly, the current $I_C$ flows through the resistor $R_5$, and the transistor $Q_{12}$ and $Q_{15}$. Therefore, the voltages $V_{C1}$ and $V_{C2}$ are low and high, respectively, as illustrated in Fig. 9.

In the read mode, since the potential of the signal $\overline{WE}$ is higher than the reference voltage $V_{R2}$, the transistors $Q_{13}$ and $Q_{14}$ are conductive, so that the current $I_C$ is divided by the transistors $Q_{13}$ and $Q_{14}$. In addition, the current flowing through the transistor $Q_{14}$ is divided by the diodes $D_1$ and $D_2$. In this case, the voltage $V_{C1}$ $(=V_{C2})$ is represented as follows.

$$V_{C1}(V_{C2}) = V_{C0} - R\alpha I_C$$

$$\alpha = \frac{A_{14}}{A_{13} + A_{14}}$$

where R is the resistance value of the resistor $R_4$ or $R_5$, and $A_{13}$ and $A_{14}$ are emitter areas of the transistors $Q_{13}$ and $Q_{14}$ respectively. Therefore,

the voltages $V_{C1}$ and $V_{C2}$ during the read mode can be higher than the lower one of the voltages $V_{C1}$ and $V_{C2}$ during the write mode, by adjusting the emitter areas of the transistor $Q_{13}$ and $Q_{14}$. As a result, the lower potential $V'_{80}$ of the selected bit lines is higher during the read mode than during the write mode.

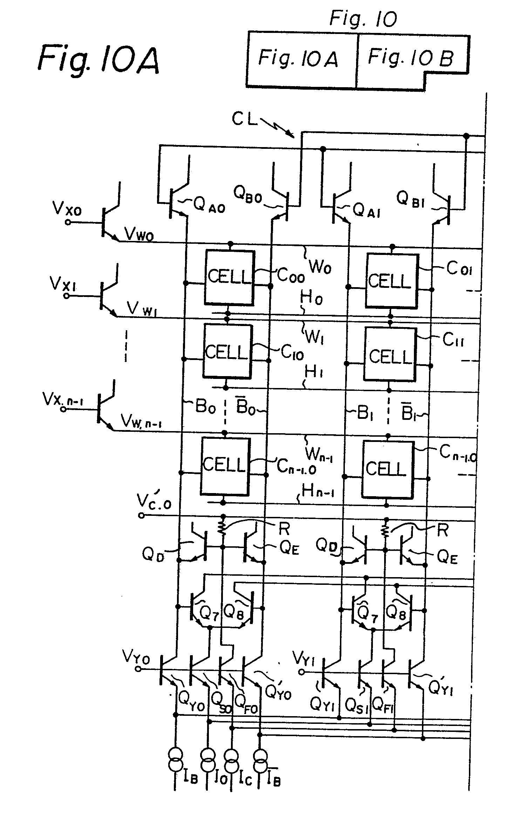

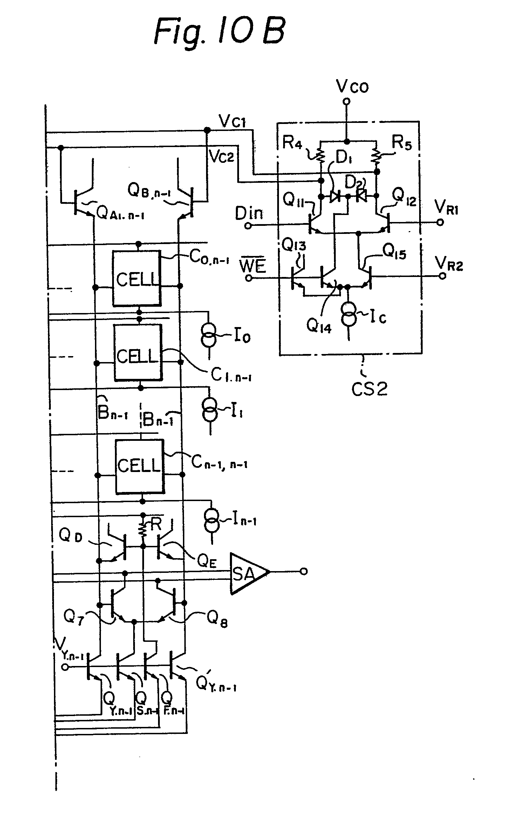

Fig. 10 is a circuit diagram illustrating a third embodiment of the I²L memory device according to the present invention. In Fig. 10, memory cells are arranged in an n row, n column matrix form. In addition, in each column, an additional clamp circuit comprising two transistors $Q_D$ and $Q_E$ connected to bit line pair, a resistor R connected to the bases of the transistors $Q_D$ and $Q_E$, and a switching transistor $Q_{Fi}$ (i=0, 1, . . ., n—1) is provided. For example, when the potentials of the signals $V_{X0}$ and $V_{Y0}$ are high, in other words, when the memory cell $C_{00}$ is selected, transistors $Q_{Y0}$ and $Q'_{Y0}$ which form a bit driver, the transistor $Q_{S0}$ for driving the differential read-out circuit formed by the transistors $Q_7$ and $Q_8$, and a transistor $Q_{F0}$ for driving the additional clamp circuit are conductive, while the other transistors $Q_{Y1}$, $Q_{Y2}$, . . ., $Q_{Y,n-1}$; $Q'_{Y1}$, $Q'_{Y2}$, . . ., $Q_{Y,n-1}$; $Q_{S1}$, $Q_{S2}$, . . ., $Q_{S,n-1}$; $Q_{F1}$, $Q_{F2}$, . . ., $Q_{F,n-1}$ are non-conductive. As a result, a high voltage $V'_{C0}$ is applied to the bases of the transistors $Q_D$ and $Q_E$ of the 1-st, 2-nd, . . ., (n—1)th columns, so that the potentials of the bit lines $B_1$, $\overline{B}_1$, $B_2$, $\overline{B}_2$, . . ., $B_{n-1}$, $\overline{B}_{n-1}$ are high, regardless of the operation of the current switching circuit CS2. Therefore, sink currents of non-selected memory cells which are not connected to the selected word line $W_0$ and the selected bit lines $B_0$ and $\overline{B}_0$ are supplied from the transistors $Q_{D1}$, $Q_{E1}$, $Q_{D2}$, $Q_{DE}$, $Q_{E2}$, $Q_{D,n-1}$, $Q_{E,n-1}$.

As explained hereinbefore, the semiconductor integrated circuit memory device according to the present invention has an advantage that the speed of the read operation is high, since the difference in potential between the selected bit lines can be reduced as compared with those of the conventional device.

In our copending application No. 80302483.5 (EP—A—23 408), we have disclosed and claimed a semiconductor integrated circuit memory device employing memory cells of the integrated injection logic type, provided with a clamp means comprising transistor pairs, each pair connected to one of the pairs of bit lines, and a control means for controlling the base potential of the transistor pairs so as to clamp the potential of the first bit line of each pair of bit lines, through which a write current flows, to be lower than that of the second bit line of each pair of bit lines in response to a write enable signal and an input data signal; and also provided with a further clamp means for raising the potentials of a non-selected pair of the said pairs of bit lines with respect to those of a selected one of the said pairs of bit lines, the selected pair being selected by the said bit driver; in this way a faster writing speed is achieved.

## Claims

1. A semiconductor integrated circuit memory device comprising: a plurality of word lines ($W_0$, $W_1$ . . . $W_{n-1}$; Fig. 10); a plurality of word drivers, each connected to one of the word lines; a plurality of hold lines ($H_0$, $H_1$, . . .; $H_{n-1}$); a plurality of pairs of bit lines ($B_0$, $\overline{B}_0$; $B_1$, $\overline{B}_1$; . . .; $B_{n-1}$, $\overline{B}_{n-1}$); a plurality of bit drivers, each connected to one of the pairs of bit lines; a plurality of memory cells of integrated injection logic ($C_{00}$, $C_{01}$, . . .; $C_{n-1, n-1}$), each memory cell including injectors comprising a pair of first and second transistors ($Q_1$, $Q_2$) of a first conduction type which have a common emitter connected to one of the word lines; a flip-flop comprising a pair of cross-coupled third and fourth transistors ($Q_3$, $Q_4$) of a second conduction type, connected to the first and second transistors, respectively; transistor means ($Q_5$, $Q_6$) coupling the third and fourth transistors to respective ones of one of the pairs of bit lines; the third and fourth transistors being connected to one of the hold lines ($H_i$); and clamping means (CL) comprising a plurality of clamp transistors ($Q_{C0}$. . .), having emitters respectively connected to the bit lines, and characterized in that the clamping means clamps the lower potential of the two potentials of each bit line pair, and by an altering means (CS1) for controlling the clamping means in accordance with a write enable signal ($\overline{WE}$) to selectively alter the base potentials of the clamp transistors in accordance with the read mode and the write mode, so that the lower potential of the clamp potentials of the bit lines is lower during the write mode than the read mode.

2. A device according to claim 1, wherein the altering means comprises a current switching circuit (CS1) for selectively clamping the bases of the clamp transistors in response to the write enable signal ($\overline{WE}$).

3. A device according to claim 2, wherein the current switching circuit (CS1, Fig. 7) comprises: a current switch comprising two transistors ($Q_9$, $Q_{10}$) controlled by the said write enable signal ($\overline{WE}$) and a reference voltage ($V_R$), respectively; a current source ($I_c$) for supplying a current to the current switch; and a resistor ($R_3$) connected to one of the two transistors.

4. A device according to claim 1, wherein the said clamping means comprises: a plurality of pairs of clamp transistors ($Q_{A0}$, $Q_{B0}$; Fig. 8), each pair connected to one of the pairs of bit lines; and wherein the altering means comprises a current switching circuit (CS2) for selectively clamping the bases of the clamp transistors in response to a write enable signal ($\overline{WE}$) and an input data signal ($D_{in}$), the clamp potentials of each bit line pair differing from each other in response to the input data so that the lower potential of the two clamp potentials of each bit line pair is higher during the read mode than during the write mode.

5. A device according to claim 4, wherein the current switching circuit comprises: a first current switch comprising two transistors ($Q_{11}$, $Q_{12}$) controlled by the input data signal ($D_{In}$) and a first reference voltage ($V_{R1}$); a second current switch comprising a further three transistors ($Q13$, $Q_{14}$, $Q_{15}$), of which two transistors ($Q13$, $Q14$) are controlled by the write enable signal ($\overline{WE}$), and the third transistor ($Q_{15}$) is controlled by a second reference voltage ($V_{R2}$) and is connected to the first current switch; a current source ($I_c$) for supplying current to the second current switch; a pair of resistors ($R_4$, $R_5$) each connected to a different one of the two transistors ($Q_{11}$, $Q_{12}$) of the first current switch; and a pair of diodes ($D_1$, $D_2$) connected in series with opposite conducting directions, the connection point of the diodes being connected to one of the said two transistors ($Q13$, $Q14$) in the second current switch controlled by the write enable signal.

6. A device according to claim 4 or 5, comprising an additional clamp circuit which includes: a plurality of pairs of clamp transistors ($Q_D$, $Q_E$; Fig. 10), each pair connected to its associated pair of bit lines; a plurality of clamp resistors (R), each one connected to a reference potential ($V_{co}^1$, Fig. 10) and to both gates of one pair of clamp transistors ($Q_D$, $Q_E$); and a plurality of switching transistors ($Q_{F0}$, $Q_{F1}$, ..., $Q_{Fn-1}$), each connecting an additional common current source ($I_c$) to both gates of one pair of clamp transistors when its associated bit column is selected.

7. A device according to any preceding claim, further comprising a differential read-out circuit for each pair of bit lines, including a pair of read-out transistors ($Q_7$, $Q_8$) whose gates are connected to the bit line pair.

8. A device according to claim 7, wherein each differential read-out circuit is driven by a driving transistor ($Q_{S0}$, $Q_{S1}$ ..., $Q_{Sn-1}$) connected to a common current source ($I_0$), and wherein the gates of the driving transistor, the switching transistor, and the bit drivers are all connected together and are supplied with a column selection signal ($V_{y0}$, $V_{y1}$, ... $V_{yn-1}$).

**Revendications**

1. Dispositif de mémoire semiconducteur à circuit intégré comprenant: plusieurs lignes de mot ($W_0$, $W_1$, ..., $W_{n-1}$; figure 10); plusieurs éléments de commande de mot connectés chacun à une des lignes de mot; plusieurs lignes de maintien ($H_0$, $H_1$, ..., $H_{n-1}$); plusieurs paires de lignes de bit ($B_0$, $\overline{B}_0$; $B_1$, $\overline{B}_1$, ...; $B_{n-1}$, $\overline{B}_{n-1}$); plusieurs éléments de commande de bit connectés chacun à une des paires de lignes de bit; plusieurs cellules de mémoire à logique d'injection intégrée ($C_{00}$, $C_{01}$, ..., $C_{n-1, n-1}$), chaque

cellule de mémoire comportant des injecteurs qui comprennent une paire d'une premier et d'un deuxième transistor ($Q_1$, $Q_2$) d'un premier type de conduction qui ont un émetteur commun connect à l'une des lignes de mot; une bascule comprenant une paire d'un troisième et d'un quatrième transistor ($Q_3$, $Q_4$) connectés en croix d'un deuxième type de conduction, qui sont respectivement connectés au premier et au deuxième transistor; un moyen à transistors ($Q_5$, $Q_6$) couplant le troisième et le quatrième transistor aux éléments respectifs de l'une des paires des lignes de bit; les troisième et quatrième transistors étant connectés à l'une des ligne de maintien $H_I$); et des moyens de verrouillage (CL) comprenant plusieurs transistors de verrouillage ($Q_{c0}$, ...) dont les émetteurs sont respectivement connectés aux lignes de bit, et caractérisé en ce que le moyen de verrouillage verrouille le potentiel le plus bas des deux potentiels de chaque paire de lignes de bit, et par un moyen d'altération (CS1) servant à commander le moyen de verrouillage en fonction d'un signal de validation d'écriture ($\overline{WE}$) afin d'altérer sélectivement les potentiels de base des transistors de verrouillage selon le mode de lecture et le mode d'écriture de façon que le potentiel le plus bas des potentiels de verrouillage des lignes de bit soit plus bas pendant le mode d'écriture que pendant le mode de lecture.

2. Dispositif selon la revendication 1, où le moyen d'altération comprend un circuit de commutation de courant (CS1) servant à verrouiller sélectivement les bases des transistors de verrouillage en réponse au signl de validation d'écriture ($\overline{WE}$).

3. Dispositif selon la revendication 2, où le circuit de commutation de courant (CS1, figure 7) comprend: un commutateur de courant comprenant deux transistors ($Q_9$, $Q_{10}$ respectivement commandés par ledit signal de validation d'écriture ($\overline{WE}$) et une tension de référence ($V_R$); une source de courant ($I_c$) servant à délivrer un courant au commutateur de courant; et une résistance ($R_3$) connectée à l'un des deux transistors.

4. Dispositif selon la revendication 1, où ledit moyen de verrouillage comprend: plusieurs paires de transistors de verrouillage ($Q_{A0}$, $Q_{B0}$; figure 8), chaque paire étant connectée à l'une des paires de lignes de bit; où ledit moyen d'altération comprend un circuit de commutation de courant (CS2) servant à verrouiller sélectivement les bases des transistors de verrouillage en réponse à un signal de validation d'écriture ($\overline{WE}$) et à un signal de donnée d'entrée ($D_{In}$), les potentiels de verrouillage de chaque paire de lignes de bit différent entre eux en fonction de la donnée d'entrée de façon que le potentiel le plus bas des deux potentiels de verrouillage de chaque paire de lignes de bit soit plus élevé pendant le mode de lecture que pendant le mode d'écriture.

5. Dispositif selon la revendication 4, où le circuit de commutation de courant comprend: un premier commutateur de courant comprenant deux transistors ($Q_{11}$, $Q_{12}$) commandés par le signal de donnée d'entrée ($D_{in}$) et un premier potentiel de référence ($V_{R1}$); un deuxième commutateur de courant comprenant trois transistors supplémentaires ($Q_{13}$, $Q_{14}$, $Q_{15}$), parmi lesquels deux transistors ($Q_{13}$, $Q_{14}$) sont commandés par le signal de validation d'écriture ($\overline{WE}$) et le troisième transistor ($Q_{15}$) est commandé par un deuxième potentiel de référence ($V_{R2}$) et est connecté au premier commutateur de courant; une source de courant ($I_c$) servant à délivrer un courant au deuxième commutateur de courant; une paire de résistances ($R_4$, $R_5$) connectées chacune à l'un différent des deux transistors ($Q_{11}$, $Q_{12}$) du premier commutateur de courant; et une paire de diodes ($D_1$, $D_2$) connectées en série de façon que leurs sens de conduction soient opposés, le point de connexion des diodes étant connecté à l'un desdits deux transistors ($Q_{13}$, $Q_{14}$) du deuxième commutateur de courant commandé par le signal de validation d'écriture.

6. Dispositif selon la revendication 4 ou 5, comprenant un circuit de verrouillage supplémentaire qui comporte: plusieurs paires de transistors de verrouillage ($Q_D$, $Q_E$; figure 10), chaque paire étant connectée à sa paire associée de lignes de bit; plusieurs résistances de verrouillage (R) connectées chacune à un potentiel de référence ($V_{c0}^1$, figure 10) et aux deux grilles d'un pair de transistors de verrouillage ($Q_D$, $Q_E$); et plusieurs transistors de commutation ($Q_{F0}$, $Q_{F1}$, ..., $Q_{Fn-1}$) connectant chacun une source de courant commune supplémentaire ($I_c$) aux deux grilles d'une paire de transistors de verrouillage lorsque sa colonne de bit associée est sélectionnée.

7. Dispositif selon l'une quelconque des revendications précédentes, comprenant en outre un circuit de lecture différentiel pour chaque paire de lignes de bit, comportant une paire de transistors de lecture ($Q_7$, $Q_8$) dont les grilles sont connectées à la pair de lignes de bit.

8. Dispositif selon la revendication 7, où chaque circuit de lecture différentielle est commandé par un transistor de commande ($Q_{S0}$, $Q_{S1}$, ..., $Q_{Sn-1}$) connecté à une source de courant commune ($I_0$) et où les grilles de transistor de commande, du transistor de commutation et les éléments de commande de bit sont tous connectés ensemble et sont alimentés au moyen d'un signal de sélection de colonne ($V_{y0}$, $V_{y1}$, ..., $V_{yn-1}$).

**Patentansprüche**

1. Integrierte Halbleiterspeichervorrichtung mit:

einer Anzahl von Wortleitungen ($W_0$, $W_1$ ... $W_{n-1}$; Fig. 10);
einer Anzahl von Worttreiberen, die jeweils mit einer der Wortleitungen verbunden sind;
einer Anzahl von Halteleitungen ($H_0$, $H_1$, ...; $H_{n-1}$);
einer Anzahl von Paaren von Bitleitungen ($B_0$, $\overline{B}_0$; $B_1$, $\overline{B}_1$; ...; $B_{n-1}$, $\overline{B}_{n-1}$);
einer Anzahl von Bittreibern, die jeweils mit einem der Paare von Bitleitungen verbunden sind;
einer Anzahl von integrierten injektionslogischen Speicherzellen ($C_{00}$, $C_{01}$, ...; $C_{n-1, n-1}$), die jeweils injektoren enthalten, die ein Paar von ersten und zweiten Transistoren ($Q_1$, $Q_2$) von einer ersten Leitfähigkeitsart umfassen, welch einen gemeinsamen Emitter haben, der mit einer der Wortleitungen verbunden ist;
einem Flipflop, welches ein Paar von über Kreuz verbundenen dritten und vierten Transistoren ($Q_3$, $Q_4$) von einer zweiten Leitfähigkeitsart umfaßt, die mit den ersten bzw. den zweiten Transistoren verbunden sind;
Transistoreinrichtungen ($Q_5$, $Q_6$), welche die dritten und vierten Transistoren mit entsprechenden von einer von den Paaren von Bitleitungen verbinden;
wobei die dritten und vierten Transistoren mit einer der Halteleitungen ($H_l$) verbunden sind; und

die Klammereinrichtungen das untere Potential von zwei Potentialen von jedem Bitleitungspaar klammern, und durch eine Änderungseinrichtung (CS1) zur Steuerung der Klammereinrichtung in Übereinstimmung mit einem Schreibaktivierungssignal ($\overline{WE}$), um wahlweise die Basispotentiale der Klammertransistoren in Übereinstimmung mit dem Lesemodus und mit dem Schreibmodus zu ändern, so daß das untere Potential des Klammerpotentials der Bitleitungen während des Scheibmodus niedriger als während des Lesemodus ist.

2. Vorrichtung nach Anspruch 1, bei welcher die Änderungseinrichtung einen Stromschaltkreis (CS1) zur wahlweisen Klammerung der Basen der Klammertransistoren in Abhängigkeit von dem Schreibaktivierungssignal ($\overline{WE}$) umfaßt.

3. Vorrichtung nach Anspruch 2, bei welcher der Stromschaltkreis (CS1, Fig. 7) umfaßt:

einen Stromschalter, der zwei Transistoren ($Q_9$, $Q_{10}$) umfaßt, die durch das genannte Schreibaktivierungssignal ($\overline{WE}$) bzw. eine Referenzspannung ($V_R$) gesteuert werden;
eine Stromquelle ($I_c$) zur Lieferung eines Stroms zu dem Stromschalter;
und einen Widerstand ($R_3$), der mit einem der beiden Transistoren verbunden ist.

4. Vorrichtung nach Anspruch 1, bei welcher die genannte Klammereinrichtung umfaßt:

eine Anzahl von Paaren von Klammertran-

sistoren ($Q_{A0}$, $Q_{B0}$; Fig. 8), von denen jedes Paar mit einem der Paare von Bitleitungen verbunden ist;

une bei welcher die Änderungseinrichtung einen Stromschaltkreis (CS2) zur wahlweisen Klammerung der Basen der Klammertransistoren in Abhängigkeit von einem Schreibaktivierungssignal ($\overline{WE}$) und einem Eingangsdatensignal ($D_{in}$), wobei die Klammerpotentiale jedes Bitleitungspaares voneinander in Abhängigkeit von den Eingangsdaten variieren, so daß das untere Potential der beiden Klammerpotentiale von jedem Bitleitungspaar während des Lesemodus höher als während des Schreibmodus ist.

5. Vorrichtung nach Anspruch 4, bei welcher der Stromschaltkreis umfaßt:

einen ersten Stromschalter, der zwei Transistoren ($Q_{11}$, $Q_{12}$) umfaßt, die durch das Eingangsdatensignal ($D_{in}$) und eine erste Referenzspannung ($V_{R1}$) gesteuert werden;

einen zweiten Stromschalter, der ferner drei Transistoren ($Q_{13}$, $Q_{14}$, $Q_{15}$) umfaßt, von denen zwei Transistoren ($Q_{13}$, $Q_{14}$) von dem Schreibaktivierungssignal ($\overline{WE}$) gesteuert werden, und der dritte Transistor ($Q_{15}$) von einer zweiten Referenzspannung ($V_{R2}$) gesteuert wird und mit dem ersten Stromschalter verbunden ist;

eine Stromquelle ($I_c$) zur Lieferung von Strom zu dem zweiten Stromschalter;

ein Paar von Widerständen ($R_4$, $R_5$), die jeweils mit einem verschiedenen von den beiden Transistoren ($Q_{11}$, $Q_{12}$) des ersten Stromschalters verbunden sind;

und ein Paar von Dioden ($D_1$, $D_2$), die in Reihe mit entgegengesetzten Durchlaßrichtungen angeschlossen sind, wobei der Verbindungspunkt der Dioden mit einem der beiden genannten Transistoren ($Q_{13}$, $Q_{14}$) in dem zweiten Stromschalter verbunden ist, die von dem Schreibaktivierungssignal gesteuert werden.

6. Vorrichtung nach Anspruch 4 oder 5, mit einer zusätzlichen Klammerschaltung, welche umfaßt:

eine Anzahl von Paaren von Klammertransistoren ($Q_D$, $Q_E$; Fig. 10), wobei jedes Paar mit seinem zugeordneten Paar von Bitleitungen verbunden ist;

einer Vielzahl von Klammerwiderständen (R), von denen jeder mit einem Referenzpotential ($V_{c0}^1$, Fig. 10) und mit beiden Gates von einem Paar von Klammertransistoren ($Q_D$, $Q_E$);

und eine Anzahl von Schalttransistoren ($Q_{F0}$, $Q_{F1}$, ..., $Q_{Fn-1}$), die jeweils eine zusätzliche gemeinsame Stromquelle ($I_c$) mit beiden Gates von einem Paar von Klammertransistoren verbinden, wenn ihre zugeordneten Bitspalten ausgewählt werden.

7. Vorrichtung nach einem der vorhergehenden Ansprüche, ferner gekennzeichnet durch eine differenzielle Ausleseschaltung für jedes Paar von Bitleitungen, welche eine Paar von Auslesetransistoren ($Q_7$, $Q_8$) umfaßt, deren Gates mit dem Bitleitungspaar verbunden sind.

8. Vorrichtung nach Anspruch 7, bei welcher jeder differenziele Auslesekreis gesteuert wird durch einen der Treibertransistoren ($Q_{S0}$, $Q_{S1}$, ..., $Q_{Sn-1}$), die mit einer gemeinsamen Stromquelle ($I_0$) verbunden sind, und bei welcher die Gates der Treibertransistoren, der Schalttransistoren und der Bittreiber alle miteinander verbunden sind und ein Spaltenauswahlsignal ($V_{y0}$, $V_{y1}$, ..., $V_{yn-1}$) empfangen.

# Fig. I

Fig. 2

2

Fig. 3 B

*Fig. 3*

| *Fig. 3 A* | *Fig. 3 B* |
|---|---|

*Fig. 3A*

# Fig. 4

WRITE MODE ——+—— READ MODE

*Fig. 5*

Fig. 6A

Fig. 6B

Fig. 6C

Fig. 7

Fig. 8

# Fig. 9

WRITE MODE ——————— READ MODE

"1" ———— "0"

$V_{co}$

$V_{c1}$

$V_{co}-R\alpha I_c$

$V_{c2}$

$V_{co}-R I_c$

Fig. 10A

Fig. 10

| Fig. 10 A | Fig. 10 B |
|-----------|-----------|

# Fig. 10 B

12